# EUROPEAN PATENT APPLICATION

(11) **EP 1 843 628 A1**
(43) Date of publication of application: **10.10.2007**
(21) Application number: 07105320.1
(22) Date of filing: 30.03.2007
(51) Int. Cl.: H04R 9/00

(54) **Miniature loudspeaker and magnetic circuit having integrated air flow passage**

(30) Priority: 07.04.2006 US 790285 P
(71) Applicant: Sonion Horsens A/S, 8700 Horsens (DK)
(72) Inventor: Andersen, Morten Kjeldsen, DK-8300, Odder (DK); Johannsen, Leif, DK-8300, Odder (DK); Laursen, Carit, DK-8700, Horsens (DK)
(74) Representative: Inspicos A/S

(57) **Abstract**

The present invention relates to a miniature electro-acoustic transducer comprising a magnetic circuit comprising a permanent magnet assembly adapted to generate a magnetic flux in an air gap, the magnetic circuit comprising a magnetically permeable yoke having one or more air flow passages arranged therein, the one or more air flow passages being in fluidic communication with the air gap to allow pressurised and/or heated air trapped blow a diaphragm of the transducer to be guided to the exterior of the magnetic circuit via said one or more air flow passages. The transducer further comprises a voice coil positioned in the air gap, the voice coil being operatively connected to the diaphragm. The one or more air flow passages are arranged in the yoke so as to guide pressurised and/or heated air in a plane being substantially perpendicular to the direction of movement of the diaphragm.

## Description

### FIELD OF THE INVENTION

The present invention relates to a miniature electro-acoustic transducer and to a magnetic circuit having one or more integrated air flow passages whereby pressurised and heated air is allowed to pass to the exterior of the magnet circuit and whereby effective cooling of internal components such as voice coils is established.

### BACKGROUND OF THE INVENTION

Future mobile phones are expected to be more compact and, nevertheless, able to produce higher sound pressure levels than mobile phones of today. Therefore, loudspeakers designed for application in mobile phones are pushed in the direction of smaller sizes, more power handling, and higher maximum sound pressure capability, etc. in order to match the above-mentioned requirements. Therefore, issues like thermal and acoustical ventilation in miniature loudspeakers or speakers become more and more critical.

US 2002/0131612 discloses a multifunctional actuator comprising a case, a diaphragm with the outer end fixed to the upper end of the case, a voice coil cylindrically wound and fixed around the lower end of the diaphragm, a main magnet magnetized in the upward and downward directions, an upper plate attached to the magnet for forming a magnetic circuit, a yoke for forming the magnetic circuit with the magnet, a weight for forming a vibrating body with the upper plate and the yoke, suspension springs for supporting the weight from the upside and downside, a vibrating coil installed in the lower end of the case for generating vibration by using a portion of magnetic flux generated as above and a ring-shaped auxiliary magnet installed in the yoke. The multifunctional actuator is arranged to provide sound pressure and vibration features in portable communication devices, such as cellular phones, PDAs, pagers and the like.

JP 2002 027 590 aims at providing an magnetic circuit to a dynamic speaker which can be made thin and light by reducing a magnetic body adhered to the rear face of a magnet. This is provided by arranging a magnetic circuit being constituted by a cylindrical centre magnet, a cylindrical outer magnet, an inner pole piece, an outer pole piece, and a resin case.

It is a disadvantage of the miniatures speakers of US 2002/0131612 and JP 2002 027 590 that no thermal ventilation is provided. Thus, there is a risk that the voice coil may reach temperatures as high as 170°C. Such temperatures will cause "thermal compression" which reduces the efficiency of the speaker in that such high temperatures will increase the ohmic resistance of the windings of the voice coil and decrease the current flow in the windings of the voice coil accordingly under constant voltage drive conditions. In worst case, the speaker will face total destruction due to a complete melt down or disintegration of the coil, damage of the diaphragm and/or disintegration of coil and diaphragm.

US 6,611,606 discloses a speaker having an associated magnet assembly. The assembly suggested in US 6,611,606 comprises first and second annular magnets positioned coaxially and forming a gap there between. The first and second magnets are axially poled and magnetically connected via a shunt. A first pole piece having a first face is positioned on the first magnet whereas a second pole piece having a second face is positioned on the second magnet. A voice coil gap is defined between the first and second faces such that magnetic flux is focused in said voice coil gap. The assembly has a through-going opening in the centre of the assembly. Pressurised and/or heated air can escape from a region below a diaphragm via the before-mentioned through-going opening. However, if the speaker disclosed in US 6,611,606 is mounted as an surface mountable device, for example against the surface of an external carrier such as a printed circuit board (PCB), air flow in the through-going opening is blocked and pressurised and/or heated air is prevented from escaping via the opening. Thus, the assembly suggested in US 6,611,606 is not suitable for being mounted directly on for example PCBs.

US 6,868,165 discloses a traditional loudspeaker comprising a magnetic flux assembly having integrated air ventilation channels. These air ventilation channels allow trapped air below a diaphragm to escape to the surroundings of the loudspeaker. However, in order to escape, the trapped air needs to travel along a rather long and complicated ventilation path including passage of a narrow air gap and passage of two hollow chambers. Thus, due to the rather long and complicated ventilation path, air in the region below the diaphragm may not always be ventilated properly.

The present invention solves these problems by providing a miniature loudspeaker and corresponding magnetic circuit comprising very short air flow passages whereby thermal compression is minimized due to effective air ventilation. By implementing air flow passages in accordance with the present invention miniature speakers of small height and high electro-acoustical conversion efficiency at high sound pressure levels can be provided. Thin speakers with a corresponding small build-in height is important to meet present and future form factor demands of portable communication devices, such as cellular or mobile phones.

A significant advantage of the miniature loudspeaker according to the present invention is that it may be mounted directly on carriers, such as PCBs, without blocking air flow passages of the loudspeaker.

### SUMMARY OF THE INVENTION

The above-mentioned object is complied with by providing, in a first aspect, a miniature electro-acoustic transducer comprising
- a magnetic circuit adapted to generate a magnetic flux in an air gap, the magnetic circuit comprising a permanent magnet assembly and a magnetically permeable yoke,
- a voice coil positioned in the air gap, the voice coil being operatively connected to a diaphragm adapted to generate sound,
wherein the magnetically permeable yoke comprises one or more air flow passages in fluidic communication with the air gap to allow pressurised and/or heated air trapped below the diaphragm to be guided to the exterior of the magnetic circuit, and
wherein the one or more air flow passages extend along a plane substantially perpendicular to a direction of movement of the diaphragm.

The magnetically permeable yoke has its primary extension in a plane being essentially parallel to a plane defined by the diaphragm whereby a majority of movements of the diaphragm occur in a direction being essentially perpendicular to the primary extension of the magnetically permeable yoke.

The present invention relates to transducers, such as loudspeakers or speakers, of miniature dimensions. The overall dimensions of the miniature loudspeaker according to the present invention is typically around 13 × 18 × 5 mm (w × I × h).

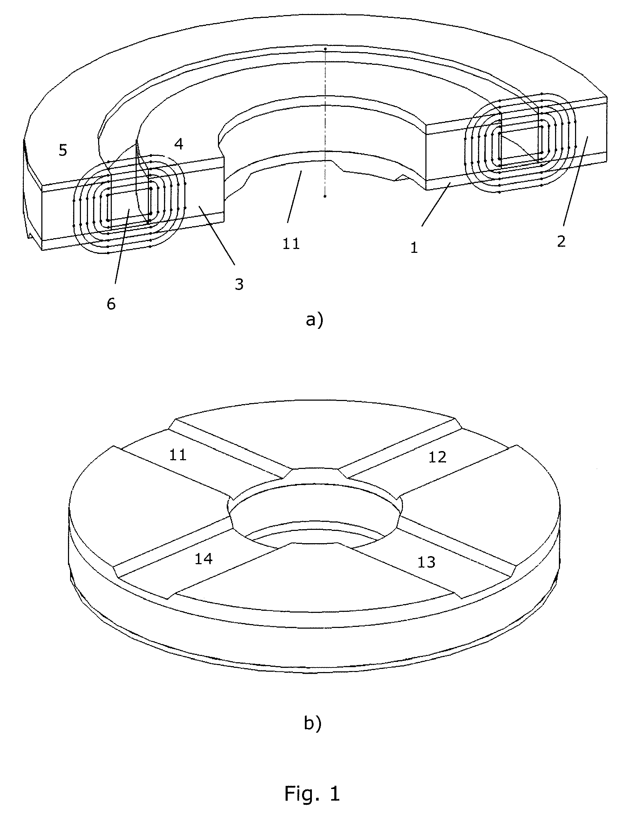

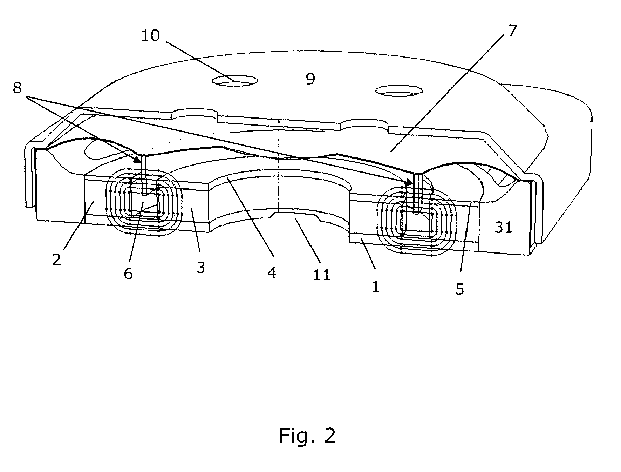

As stated above, the one or more air flow passages may be in fluidic communication with the air gap. Such fluidic communication may be provided by establishing an indirect fluidic connection between the air gap and the one or more air flow passages as suggested in the embodiments depicted in Figs. 1 and 2. By indirect fluidic connection is meant that air in the air gap cannot flow directly from the air gap to the one or more air flow passages. Alternatively, a direct fluidic connection between the air gap and the one or more air flow passages may be provided. By direct fluidic connection is meant that air in the air gap is allowed to flow directly from the air gap to the one or more air flow passages without passing any other elements or passages of the transducer.

In a first embodiment, the permanent magnet assembly may comprise an outer annular magnet arranged on the magnetically permeable yoke. In addition, the permanent magnet assembly may further comprise a centrally positioned permanent magnet arranged on the magnetically permeable yoke. The centrically positioned permanent magnet may be arranged concentrically with the outer annular magnet.

The centrically positioned permanent magnet may have various forms. For example, the centrally positioned permanent magnet may comprise an essentially solid body. Alternatively, the centrally positioned permanent magnet may have an annular shape. The permanent magnet assembly may further comprise an annular pole piece and a centre pole piece arranged on the annular magnet and the centrally positioned permanent magnet, respectively. The shape of the centre pole piece may match the shape of the centrally positioned permanent magnet. Thus, the centre pole piece may have the form of a disc, such as a circular disc, or it may have the shape of an annular pole piece.

In a second embodiment, the permanent magnet assembly may comprise a centrally positioned permanent magnet arranged on the magnetically permeable yoke having a centre pole piece arranged thereon.

The centrally positioned permanent magnet and/or the outer annular magnet may comprise NdFeB compounds having a remanence flux density of at least 1.2 T, a coercive force of at least 1000 kA/m and an energy product of at least 300 kJ/m3. As an example, an NdFeB N44H may be applied.

The fact that pressurised and/or heated air is allowed to pass through the one or more air flow passages and thereby escape an interior region of a miniature loudspeaker, ensures that the voice coil operatively connected to the diaphragm and at least partly positioned in the air gap is properly cooled. The air gap, which preferably comprises a region bounded between inner and outer surfaces of the outer annular and centrally positioned permanent magnets, respectively, may have a width in the range 0.5-0.8 mm, such as around 0.6 mm. The average magnetic flux density in the air gap may be in the range 0.3-1.5 T, such as in the range 0.5-1 T.

The impedance of the voice coil may be in the range 4- 16Ω, such as around 8Ω. Preferably, the voice coil is made of a wounded cupper wire or a wounded cupper cladding aluminium (CCA) wire. In the case of a CCA wire the cupper content may be around 15%. At typical operation an 8Ω (impedance) voice coil is driven by a voltage of around 2.8 VRMS in order to produce an electrical power of 1 W across the loudspeaker.

The air flow passage in the centrally positioned permanent magnet may be implemented in various ways. Thus, the air flow passage may comprise one or more through-going openings in the centrally positioned permanent magnet. The cross-sectional shape of these through-going openings may in principle be arbitrary. Thus, openings having substantially circular, oval or rectangular cross-sectional shapes are all suitable. Even combinations of these profiles are suitable shapes.

Preferably, the through-going opening is implemented as a cylindrical hole positioned in the centre of the centrally positioned permanent magnet. Even though the through-going opening may be positioned off-centre of the centrally positioned permanent magnet it is advantageous to position the through-going opening in the centre in that by choosing this position the generation of the magnetic field in the air gap between the centrally positioned permanent magnet and the outer annular magnet is essentially not affected.

The yoke and the centre pole piece may comprise openings aligned with the through-going opening of the centrally positioned permanent magnet. In principle, the shape and number of the openings in the yoke and in the centre pole piece may be different from that of the through-going opening of the centrally positioned permanent magnet. As long as there is a flow passage which extends through a sandwich comprising the centre pole piece, the centrally positioned permanent magnet and the yoke the air flow passage is secured.

The passage through the centre pole piece, the centrally positioned permanent magnet and the yoke may be implemented as a free passage. Alternatively, a medium, such as a shaped foam (foam plug), having predetermined acoustical properties, such as a given damping, may be positioned in the passage in order to achieve predetermined acoustical properties of a speaker applying the magnetic circuit.

The centrally positioned permanent magnet and the outer annular magnet may be arranged so as to form one or more air gaps there between. These one or more air gaps may be formed between an exterior surface part or parts of the centrally positioned permanent magnet and an exterior surface part or parts of the outer annular magnet. Depending on the shape of the centrally positioned permanent magnet and the outer annular magnet these one or more air gaps may have a circular, an oval and/or straight cross-sectional shape in a horizontal plane of the loudspeaker.

As already mentioned a centre pole piece and an annular pole piece may be provided. The average thickness of the centre pole piece arranged on the centrally positioned permanent magnet may be different, such as larger, than the average thickness of the annular pole piece arranged on the outer annular magnet. Thus, there may be sections or regions of the centre pole piece arranged on the centrally positioned permanent magnet that are thinner than sections or regions of the annular pole piece arranged on the outer annular magnet.

Suitable pole piece materials are low carbon content steel materials, such as materials similar to Werkstoff-No. 1.0330 (St 2), 1.0333 (St 3) , 1.0338 (St 4), all in accordance to DIN EN 10130.

The centrally positioned permanent magnet may, in the plane of the yoke, take a substantially ring-shaped form with the air flow passage being positioned in the centre of the magnet. In addition, the outer annular magnet may, in the plane of the yoke, take a substantially ring-shaped form with the centrally positioned permanent magnet being positioned in the centre of the opening of the outer annular magnet.

As already mentioned the miniature electro-acoustic transducer further comprises a diaphragm having one or more coils, such as voice coils, of electrically conducting wire attached thereto or integrated therewith, the one or more voice coils of electrically conducting wire being at least partly positioned in an air gap between the centrally positioned permanent magnet and the outer annular magnet. The diaphragm may be constituted by a polymer film having a thickness in the range 5-25 µm. The diaphragm may be a single-layer diaphragm, or it may be a multi-layer diaphragm where a second polymer film is attached to at least part of a bigger polymer film. By laminating a diaphragm with another diaphragm the stiffness of specific regions of the diaphragm may be significantly increased. The types of polymer films may be polyarylate (PAR), polyetherimide (PEI), polyrtheretherketone (PEEK), polyphenylene sulphide (PPS), polyethylenenapthalate (PEN), terephtalate (PET) or polycarbonate (PC).

The shape of the one or more voice coils may be given by the shape of the air gap between the centrally positioned permanent magnet and the outer annular magnet. Thus, the one or more voice coils may comprise a substantially linear portion, a curved portion or a combination thereof. The miniature electro-acoustic transducer may further comprise a cover having one or more sound outlets arranged therein.

As mentioned above the miniature electro-acoustic transducer further comprises one or more air flow passages arranged in the yoke. Said one or more air flow passages may be in fluidic communication with an air flow passage in the centrally positioned permanent magnet so that air escaping through the air flow passage in the centrally positioned permanent magnet may be guided away from the miniature transducer through these one or more flow passages in the yoke. This is of particular importance if the miniature transducer is mounted on a PCB having no opening fully or partly aligned with the air flow passage in the centrally positioned inner magnet.

In a preferred embodiment, the one or more air flow passages comprise one or more through-going passages extending through an entire thickness of the magnetically permeable yoke. Thus, the one or more air flow passages extend through the entire thickness of the yoke which has a typical thickness of 0.1-0.3 mm. By implementing the one or more air flow passages as through-going openings maximum air flow passage and thereby maximum ventilation of the voice coil is provided.

In another embodiment, the one or more air flow passages comprise one or more slits partially extending through a thickness of the magnetically permeable yoke. Thus, according to this embodiment, the one or more air flow passages extend only partially through the thickness of the yoke

A cross-sectional area of the one or more air flow passages in the magnetically permeable yoke may remain essentially constant along a radial direction of the magnetic circuit. By essentially constant is meant, that the width and height of the one or more air flow passages are kept constant. Obviously, if the one or more air flow passages are formed as through-going openings in the yoke the height of the one or more air flow passages is given by the thickness of the yoke.

Alternatively, the cross-sectional area of the one or more air flow passages in the magnetically permeable yoke may increase or decrease along a radial direction of the magnetic circuit. Thus, for example the width of the one or more air flow passages may either increase or decrease along the radial direction of the magnetic circuit. By varying the dimensions of the cross-sectional area of the one or more air flow passages the acoustical coupling to the exterior of the magnetic circuit may be varied to match specific demands. In terms of shape the one or more air flow passages may take different shapes. Thus, a number of air flow passages may have an essentially constant cross-sectional area whereas other air flow passages may have a cross-sectional area which changes, increases or decreases, along the radial direction of the magnetic circuit.

Each of the one or more air flow passages may comprise an inner end part spatially overlapping with the air gap, and an outer end part at or near an exterior portion of the magnetic circuit. Thus, the inner end parts of the one or more air flow passages are in direct fluidic communication with the air gap. The outer end part may comprise a pair of outwardly curved sidewall portions arranged to avoid generation of turbulent air flow at the outer end part. By avoiding turbulent air flows in the one or more air flow passages maximum ventilation of the voice coil is provided.

For air flow passages having larger cross-sectional areas the risk of contamination and foreign objects entering the passages increases. Thus, a dust blocking arrangement may advantageously be provided in at least one of the one or more air flow passages.

In a second aspect, the present invention relates to a magnetic circuit comprising a permanent magnet assembly adapted to generate a magnetic flux in an air gap, the magnetic circuit comprising a magnetically permeable yoke having one or more air flow passages arranged therein, the one or more air flow passages being in fluidic communication with the air gap to allow pressurised and/or heated to be guided to the exterior of the magnetic circuit via said one or more air flow passages, wherein the one or more air flow passages extend along a plane that is substantially perpendicular to a direction of movement of an associated diaphragm.

Again, the yoke has its primary extension in a plane being essentially parallel to a plane defined by the diaphragm whereby a majority of movements of the diaphragm occur in a direction being essentially perpendicular to the primary extension of the yoke.

Similar to the first aspect of the present invention, the permanent magnet assembly may comprise an outer annular magnet arranged on the magnetically permeable yoke. The permanent magnet assembly may further comprise a centrally positioned permanent magnet arranged on the magnetically permeable yoke and concentric with the outer annular magnet. The centrally positioned permanent magnet may comprise an essentially solid body, or, alternatively, the centrally positioned permanent magnet may have an annular shape. An annular pole piece and a centre pole piece may be arranged on the annular magnet and the centrally positioned permanent magnet, respectively.

Alternatively, the outer annular magnet may be omitted. Thus, the permanent magnet assembly may comprise a centrally positioned permanent magnet only, said centrally positioned permanent magnet being arranged on the magnetically permeable yoke. A centre pole piece may be arranged on the centrally positioned permanent magnet.

In a preferred embodiment, the one or more air flow passages comprise one or more through-going passages extending through an entire thickness of the magnetically permeable yoke. Thus, the one or more air flow passages extend through the entire thickness of the yoke which has a typical thickness of 0.1-0.3 mm. By implementing the one or more air flow passages as through-going openings maximum air flow passage and thereby maximum ventilation of the voice coil is provided.

In another embodiment, the one or more air flow passages comprise one or more slits partially extending through a thickness of the magnetically permeable yoke. Thus, according to this embodiment, the one or more air flow passages extend only partially through the thickness of the yoke.

A cross-sectional area of the one or more air flow passages in the magnetically permeable yoke may remain essentially constant along a radial direction, of the magnetic circuit. By essentially constant is meant, that the width and height of the one or more air flow passages are kept essentially constant. Obviously, if the one or more air flow passages are formed as through-going openings in the yoke the height of the one or more air flow passages is given by the thickness of the yoke.

Alternatively, the cross-sectional area of the one or more air flow passages in the magnetically permeable yoke may increase or decrease along a radial direction of the magnetic circuit. Thus, for example the width of the one or more air flow passages may either increase or decrease along the radial direction of the magnetic circuit. By varying the dimensions of the cross-sectional area of the one or more air flow passages the acoustical coupling to the exterior of the magnetic circuit may be varied to match specific demands. In terms of shape the one or more air flow passages may take different shapes. Thus, a number of air flow passages may have an essentially constant cross-sectional area whereas other air flow passages may have a cross-sectional area which changes, increases or decreases, along the radial direction of the magnetic circuit.

Each of the one or more air flow passages may comprise an inner end part spatially overlapping with the air gap, and an outer end part at or near an exterior portion of the magnetic circuit. Thus, the inner end parts of the one or more air flow passages are in direct fluidic communication with the air gap. The outer end part may comprise a pair of outwardly curved sidewall portions arranged to avoid generation of turbulent air flow at the outer end part. By avoiding turbulent air flows in the one or more air flow passages maximum ventilation of the voice coil is provided.

For air flow passages having larger cross-sectional areas the risk of contamination and foreign objects entering the passages increases. Thus, a dust blocking arrangement may advantageously be provided in at least one of the one or more air flow passages.

In a third aspect the present invention relates to a portable communication device comprising a miniature electro-acoustic transducer according to the first aspect, the portable communication device being selected from a group consisting of: cellular phones, PDAs, game consoles and portable computers.

The above summary of the present invention is not intended to represent each embodiment, or every aspect, of the present invention. This is the purpose of the figures and the detailed description which follow.

### BRIEF DESCRIPTION OF THE DRAWINGS

The present invention will now be explained in further details with reference to the accompanying figures, wherein
Fig. 1 shows a cross-sectional view of a miniature magnetic circuit having an air flow passage in the centrally positioned permanent magnet and air flow passages in the yoke.
Fig. 2 shows cross-sectional views of a miniature loudspeaker having a magnetic circuit having an air flow passage.
Fig. 3 shows a comparison of output signals from a miniature loudspeaker having no air flow passage and a miniature loudspeaker having an air flow passage.
Fig. 4 shows various implementations of the air flow passages in the yoke.
Fig. 5 shows a cross-sectional view of a miniature loudspeaker having air flow passages in the yoke.
Fig. 6 shows a miniature loudspeaker having flared air flow passages.
Fig. 7 shows a bottom view of a loudspeaker having air flow passages in the yoke.

While the invention is susceptible to various modifications and alternative forms, specific embodiments have been shown by way of example in the drawings and will be described in detail herein. It should be understood, however, that the invention is not intended to be limited to the particular forms disclosed. Rather, the invention is to cover all modifications, equivalents, and alternatives falling within the spirit and scope of the invention as defined by the appended claims.

### DETAILED DESCRIPTION OF THE INVENTION

In its broadest aspect the present invention relates to a miniature loudspeaker and a magnetic system (motor) for such miniature loudspeaker optimized for maximum motor force and enhanced thermal and acoustical ventilation. Thermal ventilation is needed due to very high temperatures of the voice coil when the loudspeaker or speaker is operating at its maximum power capability where the temperature of the voice coil may reach 170°C. Such elevated temperatures will result in "thermal compression" which reduces the electro-acoustical conversion efficiency of the speaker. In worst case the loudspeaker will face total destruction due to a complete melt down or disintegration of the coil, damage of the diaphragm and/or disintegration of coil and diaphragm. The air flow passages of the magnetic circuit according to the present invention provide fluidic communication between the air around the voice coil and the exterior of the magnetic circuit whereby optimal cooling of the voice coil is provided. In addition, acoustical ventilation is important in order to avoid a so-called"pumping''effect at high sound pressure levels. Such pumping effect will result in a collapse of the membrane whereby sound pressures at high frequencies will become significantly reduced and the distortion will increase accordingly.

The miniature loudspeaker and magnetic circuit according to the present invention can be further optimized by differentiating the thickness of the magnets as well as the thicknesses of the pole pieces. Especially, a thicker centre pole piece can increase the magnetic field-see the description below. Also, the soft iron alloy can be optimized to ensure maximum magnetic motor force by use of alloys containing cobalt. Such alloys typically contain between 17 and 50% cobalt. Not all pole pieces will provide the same advantages by using cobalt-containing iron.

Referring now to Fig. 1 a miniature magnetic circuit according to the present invention is depicted. The magnetic circuit is constituted by a magnetically permeable yoke 1, outer annular magnet 2, a centrally positioned permanent magnet 3, an centre magnetically permeable pole piece 4 and an outer magnetically permeable pole piece 5. These elements, i.e. two magnets and three pole pieces, are brought together to form a sandwich structure.

As depicted in Fig. 1 the centrally positioned permanent magnet 3 has a through-going hole arranged therein. The through-going hole in the centre part of the centrally positioned permanent magnet only influences the achievable motor force very little. This through-going hole creates, along with holes in the centre pole piece 4 and the yoke 1, a passage between the region above the magnetic circuit and the region below the magnetic circuit. By providing this passage pressurised and heated air above the magnetic circuit can escape through the through-going hole in the centrally positioned permanent magnet whereby cooling of electronic elements, such as voice coils, is effectively established. A more detailed description of this cooling mechanism will be given in connection with Fig. 2.

The passage in the centrally positioned permanent magnet 3 can, as depicted in Fig. 1, be implemented as a free passage. Alternative, a medium, such as a shaped foam (foam plug), having predetermined acoustical properties, such as a given damping, can be positioned in the passage in order to achieve predetermined acoustical properties of the speaker applying the magnetic circuit of Fig. 1.

In the embodiment depicted in Fig. 1, air flow passages 11, 12, 13, 14 are arranged as indentations in the yoke. As seen the four air flow passages are in fluidic communication with the air flow passage in the centrally positioned permanent magnet so that air escaping through the centrally positioned permanent magnet is allowed to pass to the exterior of the miniature loudspeaker through the four air flow passages in the yoke. This is of particular importance in case the miniature loudspeaker is arranged directly on a PCB not having a hole aligned with the air flow passage of the centrally positioned permanent magnet. In Fig. 1 the air flow passages are arranged as indentations in the surface adapted to face the PCB. Alternatively, the air flow passages can be implemented as through-going openings or slits in the yoke.

As seen in Fig. 1, the thickness of the centre pole piece 4 has been made thicker than the thickness of the outer pole piece 5. This increased thickness of the centre pole piece increases the magnetic field in the air gap 6 between the centrally positioned permanent magnet and the outer annular magnet. The generated flux lines in the air gap between the centrally positioned permanent magnet and the outer annular magnet are also depicted in Fig. 1.

The magnetic circuit is in Fig. 1 depicted as being circular. However, the magnetic circuit may in principle take any form such as oval or rectangular. The magnetic circuit has a diameter of around 10 mm in diameter and a thickness of around 1 mm.

A cross-sectional view of a miniature loudspeaker is shown in Fig. 2. Again, the yoke 1, the outer annular magnet 2, the centrally positioned permanent magnet 3, the pole pieces 4, 5 and the air gap 6 is shown. In addition to this, a diaphragm 7, a voice coil 8, a cover 9 with openings 10 (sound outlets) arranged therein and a supporting frame 31 is shown. As seen, the lower part of the voice coil 8, which is constituted by a wounded wire, is positioned in the air gap between the centrally positioned permanent magnet 3 and the outer annular magnet 2. Since the voice coil 8 experiences a magnetic field, the diaphragm 7 can be moved towards and away from the magnetic circuit by passing a current through the windings of the voice coil 8. This movement of the diaphragm 7 produces a sound pressure, and thereby an audible signal, when current is passed through of the voice coil 8.

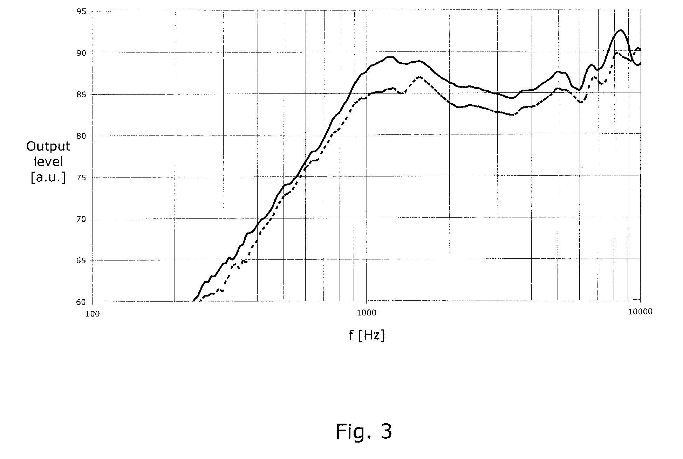

In Fig. 3, the sound pressure level from a miniature loudspeaker without air flow passage(s) is compared to the sound pressure level of a miniature speaker with air flow passage to the exterior of the speaker. The measurements have been made at maximum power handling level for both loudspeaker variants. Both loudspeaker variants were driven by a constant voltage source. The solid line shows the sound pressure level of the speaker with air flow passage, whereas the dashed line indicates the sound pressure level from the speaker without air flow passage. The sound pressure levels are shown as functions of frequency. Except for frequencies around 10 kHz, which are insignificant for the present application, the miniature loudspeaker with air flow passage produces the highest sound pressure level.

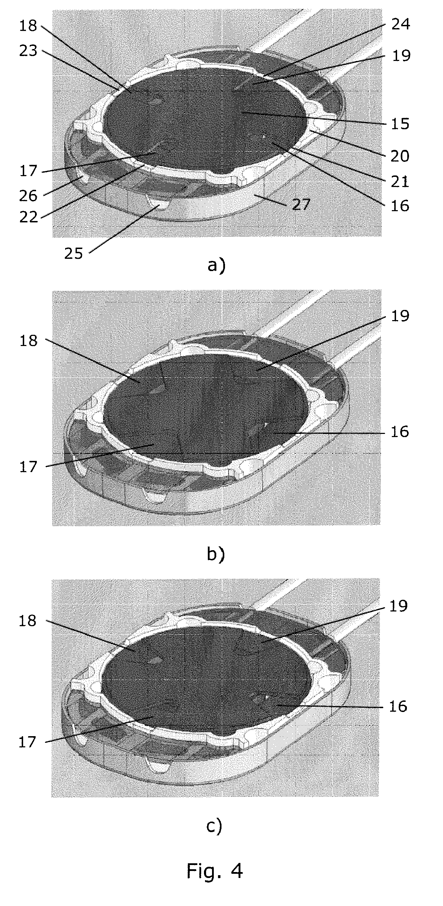

Now referring to Figs. 4a-c, three different ways of implementing the air flow passages in the yoke is depicted. In Fig. 4a, a bottom view of a miniature loudspeaker is depicted. The miniature loudspeaker comprises a magnetic circuit having a yoke 15 with four air flow passages 16, 17, 18, 19 arranged therein. The rounded end of each of these air flow passages is in direct fluidic communication with the air gap (not shown) of the magnetic circuit. The width of each of the four air flow passages along a radial direction is essentially constant. Air guided in the air flow passages is allowed to reach the exterior of the magnetic circuit via ports 21, 22, 23, 24 arranged in the internal housing 20. Further openings 25, 26 in the outer part 27 of the housing allow fluidic communication with the exterior of the miniature loudspeaker.

In Fig. 4b, each of the four air flow passages in the magnetically permeable yoke has a shape as a quarter of a circular disc. This shape ensures that an increased amount of air is allowed to pass through the air flow passages. The same applies to the air flow passages depicted in Fig. 4c. Thus, by varying the dimensions and the shape of the air flow passages the volume per time unit of air that is allowed to escape to the exterior of the magnetic circuit can be adjusted to match specific demands.

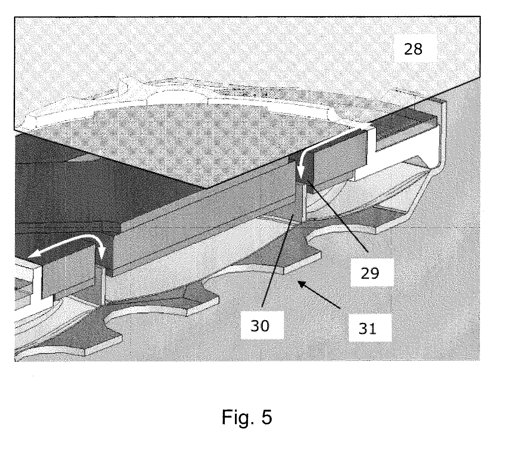

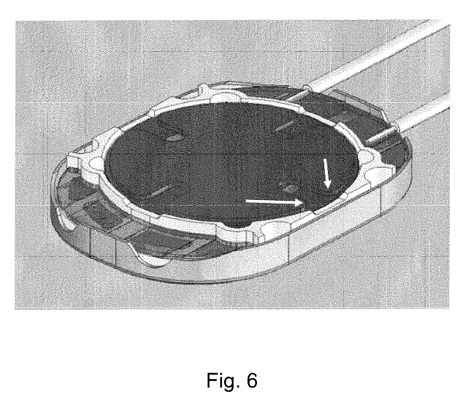

In Fig. 5 a miniature loudspeaker arranged on a flat surface 28, such as a PCB, is depicted. As indicated by the two white arrows air is allowed to pass freely from the air gap 29 to the exterior of the magnetic circuit whereby the voice coil 30 positioned in the air gap is effectively cooled. Fig. 6 depicts a miniature loudspeaker having air flow passages configured to avoid turbulence air flows in the passages. As indicated by the arrows the corners bridging the passages and the exterior of the magnetic circuit are curved. Other arrangements for avoiding turbulent flow in the air flow passages are also applicable.

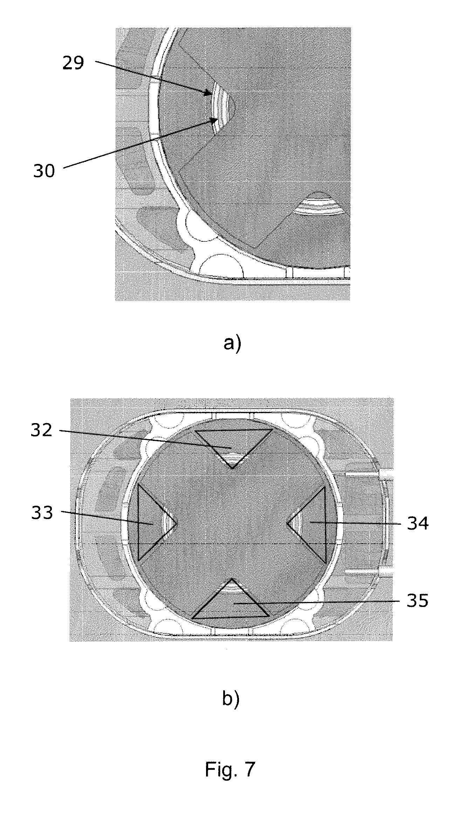

As previously mentioned, the air flow to and from the voice coils can be adjusted by varying the dimensions and the shape of the air flow passages. Especially by increasing the depth of the air flow passages in the radial direction of an essentially circular magnetic circuit increases the spatial overlap with the air gap 29 in which the voice coil 30 is positioned-see Fig. 7a. However, by the increasing the dimensions of the air flow passages the risk of contamination of the passages by for example foreign objects such as dust particles increases. So, for large air flow passages it might be advantageous to position a mesh or grid in one or more of the air flow passages (indicated as hashed region 32, 33, 34, 35 in Fig. 7b) so as to avoid that particles or other foreign objects enter and potentially block one or several of the air flow passages.

At high drive currents the temperature of the windings of the voice coil increases dramatically whereby air trapped between pole pieces 4, 5 and the diaphragm 7 is subjected to a significant temperature increase. In absence of the air flow passages to the surroundings pressurised and heated air (trapped between pole pieces 4, 5 and the diaphragm 7) is prevented from escaping whereby decreasing of the voice coil 8 temperature can only be established by reducing the drive current passed through the voice coil itself. This reduced current to the voice coil 8 immediately reduces the sound pressure generated by the speaker.

If high sound pressure levels are required over longer periods of time some sort of cooling of the voice coil is required. According to the present invention this cooling is provided by arranging a passage to the exterior of the miniature loudspeaker whereby overheating of the windings of the voice coil can be avoided. As a result the miniature loudspeaker according to the present invention is capable of generating high sound pressure levels over a long period of time.

While the present invention has been described with reference to one or more particular embodiments, those skilled in the art will recognize that many changes may be made thereto without departing from the spirit and scope of the present invention. Each of these embodiments and obvious variations thereof is contemplated as falling within the spirit and scope of the claimed invention, which is set forth in the following claims.

## Claims

1. A miniature electro-acoustic transducer comprising
- a magnetic circuit adapted to generate a magnetic flux in an air gap, the magnetic circuit comprising a permanent magnet assembly and a magnetically permeable yoke,
- a voice coil positioned in the air gap, the voice coil being operatively connected to a diaphragm adapted to generate sound,
wherein the magnetically permeable yoke comprises one or more air flow passages in fluidic communication with the air gap to allow pressurised and/or heated air trapped below the diaphragm to be guided to the exterior of the magnetic circuit, and
wherein the one or more air flow passages extend along a plane substantially perpendicular to a direction of movement of the diaphragm.

2. A miniature electro-acoustic transducer according to claim 1, wherein the permanent magnet assembly comprises an outer annular magnet arranged on the magnetically permeable yoke.

3. A miniature electro-acoustic transducer according to claim 2, wherein the permanent magnet assembly further comprises a centrally positioned permanent magnet arranged on the magnetically permeable yoke, the centrally positioned permanent magnet being concentrically arranged with the outer annular magnet.

4. A miniature electro-acoustic transducer according to claim 3, wherein the centrally positioned permanent magnet comprises an essentially solid body.

5. A miniature electro-acoustic transducer according to claim 3, wherein the centrally positioned permanent magnet has an annular shape.

6. A miniature electro-acoustic transducer according to any of claim 3-5, wherein the permanent magnet assembly further comprises an annular pole piece and a centre pole piece arranged on the annular magnet and the centrally positioned permanent magnet, respectively.

7. A miniature electro-acoustic transducer according to claim 1, wherein the permanent magnet assembly comprises a centrally positioned permanent magnet arranged on the magnetically permeable yoke.

8. A miniature electro-acoustic transducer according to claim 7, wherein the permanent magnet assembly further comprises a centre pole piece arranged on the centrally positioned permanent magnet.

9. A miniature electro-acoustic transducer according to any of the preceding claims, wherein the one or more air flow passages comprises one or more through-going passages extending through an entire thickness of the magnetically permeable yoke.

10. A miniature electro-acoustic transducer according to any of claims 1-8, wherein the one or more air flow passages comprises one or more slits partially extending through a thickness of the magnetically permeable yoke.

11. A miniature electro-acoustic transducer according to any of the preceding claims, wherein a cross-sectional area of the one or more air flow passages in the magnetically permeable yoke remains essentially constant along a radial direction of the magnetic circuit.

12. A miniature electro-acoustic transducer according to any of claims 1-10, wherein a cross-sectional area of the one or more air flow passages in the magnetically permeable yoke increases along a radial direction of the magnetic circuit.

13. A miniature electro-acoustic transducer according to any of claims 1-10, wherein a cross-sectional area of the one or more air flow passages in the magnetically permeable yoke decreases along a radial direction of the magnetic circuit.

14. A miniature electro-acoustic transducer according to any of the preceding claims, wherein each of the one or more air flow passages comprises an inner end part spatially overlapping with the air gap, and an outer end part at or near an exterior portion of the magnetic circuit.

15. A miniature electro-acoustic transducer according to claim 14, wherein the outer end part comprises a pair of outwardly curved sidewall portions arranged to avoid generation of turbulent air flow at the outer end part.

16. A miniature electro-acoustic transducer according to any of the preceding claims, wherein a dust blocking arrangement is provided in at least one of the one or more air flow passages.

17. A magnetic circuit comprising a permanent magnet assembly adapted to generate a magnetic flux in an air gap, the magnetic circuit comprising a magnetically permeable yoke having one or more air flow passages arranged therein, the one or more air flow passages being in fluidic communication with the air gap to allow pressurised and/or heated to be guided to the exterior of the magnetic circuit via said one or more air flow passages, wherein the one or more air flow passages extend along a plane substantially perpendicular to a direction of movement of an associated diaphragm.

18. A magnetic circuit according to claim 17, wherein the permanent magnet assembly comprises an outer annular magnet arranged on the magnetically permeable yoke.

19. A magnetic circuit according to claim 18, wherein the permanent magnet assembly further comprises a centrally positioned permanent magnet arranged on the magnetically permeable yoke, the centrally positioned permanent magnet being concentrically arranged with the outer annular magnet.

20. A magnetic circuit according to claim 19, wherein the centrally positioned permanent magnet comprises an essentially solid body.

21. A magnetic circuit according to claim 19, wherein the centrally positioned permanent magnet has an annular shape.

22. A magnetic circuit according to any of claim 19-21, wherein the permanent magnet assembly further comprises an annular pole piece and a centre pole piece arranged on the annular magnet and the centrally positioned permanent magnet, respectively.

23. A magnetic circuit according to claim 17, wherein the permanent magnet assembly comprises a centrally positioned permanent magnet arranged on the magnetically permeable yoke.

24. A magnetic circuit according to claim 23, wherein the permanent magnet assembly further comprises a centre pole piece arranged on the centrally positioned permanent magnet.

25. A magnetic circuit according to any of claims 17-24, wherein the one or more air flow passages comprises one or more through-going passages extending through an entire thickness of the magnetically permeable yoke.

26. A magnetic circuit according to any of claims 17-24, wherein the one or more air flow passages comprises one or more slits partially extending through a thickness of the magnetically permeable yoke.

27. A magnetic circuit according to any of claims 17-26, wherein a cross-sectional area of the one or more air flow passages in the magnetically permeable yoke remains essentially constant along a radial direction of the magnetic circuit.

28. A magnetic circuit according to any of claims 17-26, wherein a cross-sectional area of the one or more air flow passages in the magnetically permeable yoke increases along a radial direction of the magnetic circuit.

29. A magnetic circuit according to any of claims 17-26, wherein a cross-sectional area of the one or more air flow passages in the magnetically permeable yoke decreases along a radial direction of the magnetic circuit.

30. A magnetic circuit according to any of claims 17-29, wherein each of the one or more air flow passages comprises an inner end part spatially overlapping with the air gap, and an outer end part at or near an exterior portion of the magnetic circuit.

31. A magnetic circuit according to claim 30, wherein the outer end part comprises a pair of outwardly curved sidewall portions arranged to avoid generation of turbulent air flow at the outer end part.

32. A magnetic circuit according to any of claims 17-31, wherein a dust blocking arrangement is provided in at least one of the one or more air flow passages.
